# EUROPEAN PATENT APPLICATION

(11) **EP 4 380 135 A1**
(43) Date of publication of application: **05.06.2024**
(21) Application number: 22849692.3
(22) Date of filing: 27.05.2022
(51) Int. Cl.: H04M 1/02, H05K 5/00, C25D 11/22, C25D 11/26

(54) **ELECTRONIC DEVICE FRAME, AND ELECTRONIC DEVICE INCLUDING SAME**

(30) Priority: 26.07.2021 KR 20210097986
(71) Applicant: Samsung Electronics Co., Ltd., Suwon-si, Gyeonggi-do 16677 (KR)
(72) Inventor: KIM, Jungchul, Suwon-si, Gyeonggi-do 16677 (KR); KWON, Sooncheol, Suwon-si, Gyeonggi-do 16677 (KR); KIM, Sunghoon, Suwon-si, Gyeonggi-do 16677 (KR); CHOI, Byounghee, Suwon-si, Gyeonggi-do 16677 (KR); HWANG, Yongwook, Suwon-si, Gyeonggi-do 16677 (KR)
(74) Representative: Nederlandsch Octrooibureau
(86) International application number: PCT/KR2022/007530
(87) International publication number: WO 2023/008713

(57) **Abstract**

An electronic device frame and an electronic device including the electronic device frame are provided. According to certain example embodiments, the electronic device frame may include a support member. The support member may include a surface area within a predetermined depth from a surface, and a core area corresponding to an area other than the surface area. The surface area may include a planar portion and a plurality of concave portions. An oxide film may be formed on a surface of the support member, and an amount of silicon in the surface area may be less than an amount of silicon in the core area. In addition, various other example embodiments are possible.

## Description

### BACKGROUND

### 1. Field

One or more embodiments of the instant disclosure generally relates to an electronic device frame and an electronic device including a corrosion-resistant support member.

### 2. Description of Related Art

Electronic device referred to herein may be a device that performs specific functions according to various programs, and may be a home appliance, an electronic note device, a portable multimedia player, a mobile communication terminal, a tablet personal computer (PC), a video/audio device, a desktop/laptop computer, a vehicle navigation system, and the like. For example, such electronic devices may output stored information as sound or images. As electronic devices are increasingly integrated with various services, and as ultra-high-speed communication has become increasingly commonplace, an electronic device such as a mobile communication terminal may perform large capacity wireless communication as well as other functions or services. For example, entertainment functions such as gaming, multimedia functions such as music/video play, communication and security function for mobile banking, scheduling function, and electronic wallet function as well as communication function have been integrated in a single electronic device.

These electronic devices may each include a support member and a housing made of various materials. The housing and the support member of the electronic device are configured to protect the internal components of the electronic device from external impact. In addition, the housing and the support member of the electronic device may be manufactured to be portable and to provide an aesthetically pleasing appearance. The housing and the support member of the electronic device may have high corrosion resistance by having an oxide film on surfaces thereof through an anodizing process, thereby reducing corrosion due to external environment and preventing the current generated in the device's battery from leaking.

### SUMMARY

According to certain example embodiments, an electronic device frame including a support member having a surface on which an oxide film is continuously formed may be provided.

According to certain example embodiments, an electronic device frame including two or more areas in which amounts of silicon contained in the two or more areas are different may be provided.

A support member of an electronic device frame according to certain example embodiments may include a surface area and a core area, and the amount of silicon in the surface area and the amount of silicon content in the core area may be different from each other.

According to certain example embodiments, the amount of silicon in the surface area may be less than the amount of silicon in the core area, and an oxide film may be continuously formed on a surface of the support member.

An electronic device according to certain example embodiments may include an electronic device frame including a support member, a front plate, and a rear plate.

A method of manufacturing an electronic device frame according to certain example embodiments may include casting of a support member, manufacturing of the electronic device frame, and performing of anodizing on the electronic device frame.

According to certain example embodiments, it is possible to provide an electronic device frame including a support member having a surface on which an oxide film is continuously formed.

According to certain example embodiments, it is possible to provide an electronic device frame including two or more areas having different amounts of silicon.

Additional aspects will be set forth in part in the description which follows and, in part, will be apparent from the description, or may be learned by practice of the presented embodiments.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a perspective view illustrating a front surface of a mobile electronic device according to an example embodiment;
FIG. 2 is a perspective view of a rear surface of the electronic device of FIG. 1;
FIG. 3 is an exploded perspective view of the electronic device of FIG. 1;
FIG. 4 is a cross-sectional view of an electronic device frame according to an example embodiment;
FIG. 5 is a partial cross-sectional view of a support member according to an example embodiment;
FIG. 6 is a flowchart illustrating a method of manufacturing an electronic device frame according to an example embodiment;
FIGS. 7A to 7C are schematic diagrams showing an interface weakening process of a support member according to an example embodiment; and
FIGS. 8 and 9 are flowcharts illustrating methods of manufacturing an electronic device frame according to certain example embodiments.

### DETAILED DESCRIPTION

Hereinafter, example embodiments will be described in detail with reference to the accompanying drawings. When describing the example embodiments with reference to the accompanying drawings, like reference numerals refer to like elements and a repeated description related thereto will be omitted.

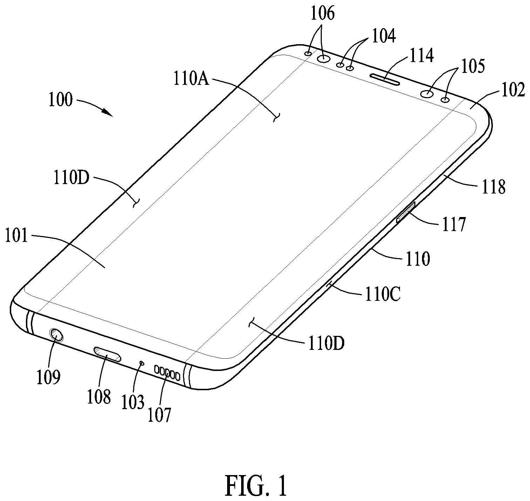

FIG. 1 is a perspective view illustrating a front surface of a mobile electronic device according to an example embodiment;

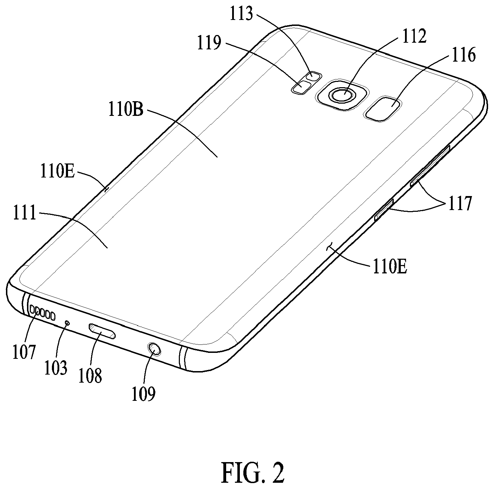

FIG. 2 is a perspective view of a rear surface of the electronic device of FIG. 1.

Referring to FIGS. 1 and 2, an electronic device 100 according to an example embodiment may include a housing 110 including a first surface (or a front surface) 110A, a second surface (or a rear face) 110B, and a side surface 110C surrounding a space between the first surface 110A and the second surface 110B. In an example embodiment (not shown), the housing may also refer to a structure which forms a portion of the first surface 110A, the second surface 110B, and the side surface 110C of FIG. 1. According to an example embodiment, the first surface 110A may be formed by a front plate 102 (e.g., glass plate or polymer plate including various coating layers) of which at least a portion is substantially transparent. The second surface 110B may be formed of a rear plate 111 that is substantially opaque. For example, the rear plate 111 may be made of coated or colored glass, ceramic, polymer, metal materials (e.g. Aluminum, stainless steel (SS), or magnesium), or a combination of at least two of the above materials. The side surface 110C may be coupled to the front plate 102 and the rear plate 111 and may be formed by a side bezel structure (or "side member") 118 that includes metal and/or polymer. In an example embodiment, the rear plate 111 and the side bezel structure 118 may be integrated together and may include the same material (e.g., metal such as aluminum).

In the illustrated example embodiment, the front plate 102 may include two first areas 110D that are curved and extended seamlessly from the first surface 110A toward the rear plate 111 at the two longitudinal edges of the front plate 102. In the illustrated example embodiment (see FIG. 2), the rear plate 111 may include two second areas 110E that are curved and extended seamlessly from the second surface 110B toward the front plate 102 at the two longitudinal edges thereof. In some example embodiments, the front plate 102 (or the rear plate 111) may include only one of the first areas 110D (or the second areas 110E). In an example embodiment, some of the first areas 110D or the second area 110E may not be included. In the above example embodiments, in a side view of the electronic device 100, the side bezel structure 118 may have a first thickness (or width) at a side in which the first areas 110D or the second areas 110E are not included, and may have a second thickness less than the first thickness at a side in which the first areas 110D or the second areas 110E are included.

According to an example embodiment, the electronic device 100 may include at least one of a display 101, audio modules 103, 107, and 114, sensor modules 104, 116, and 119, camera modules 105, 112, and 113, key input devices 117, a light-emitting element 106, and connector holes 108 and 109. In some example embodiments, the electronic device 100 may not include at least one (e.g., the key input devices 117 or the light-emitting element 106) of the components, or may additionally include other components.

The display 101 may be visually exposed through a majority portion of the front plate 102, for example. In some example embodiments, at least a portion of the display 101 may be visually exposed through the first surface 110A and the front plate 102 that forms the first areas 110D of the side surface 110C. In some example embodiments, a corner of the display 101 may be shaped to correspond to the shape of an outer portion of the front plate 102 adjacent thereto. In an example embodiment (not shown), to increase the area where the display 101 is exposed, the distance between the outer portion of the display 101 and the outer portion of the front plate 102 may be constant all along the circumference of the outer portions.

In an example embodiment (not shown), a recess or an opening may be formed in a portion of a screen display area of the display 101, and at least one of the audio module 114, the sensor module 104, and the camera module 105, and the light-emitting element 106 that are aligned with the recess or the opening may be included. In an example embodiment (not shown), at least one of the audio module 114, the sensor module 104, the camera module 105, the sensor module 116 (i.e., a fingerprint sensor), and the light-emitting element 106 may be included on a rear surface of the screen display area of the display 101. In an example embodiment (not shown), the display 101 may be coupled to or disposed adjacent to a touch sensing circuit, a pressure sensor for measuring intensity (pressure) of touches, and/or a digitizer for detecting a magnetic-type stylus pen. In some example embodiments, at least a portion of the sensor modules 104 and 119, and/or at least a portion of the key input devices 117 may be disposed in the first areas 110D and/or the second areas 110E.

The audio modules 103, 107, and 114 may include a microphone hole (i.e., the audio module 103) and speaker holes (i.e., the audio modules 107 and 114). A microphone for acquiring external sound may be disposed in the microphone hole (i.e., the audio module 103). In some example embodiments, a plurality of microphones may be disposed to detect the direction of sound. The speaker holes (i.e., the audio modules 107 and 114) may include an external speaker hole (i.e., the audio module 107), and a receiver hole (i.e., the audio module 114) for telephone calls. In some example embodiments, the speaker holes (i.e., the audio modules 107 and 114) and the microphone hole (i.e., the audio module 103) may be implemented as a single hole, or a speaker (e.g., piezo speaker) may be included that does not need speaker holes (i.e., the audio modules 107 and 114).

The sensor modules 104, 116, and 119 may generate electrical signal or data value corresponding to an internal operating state of the electronic device 100 or an external environmental state. The sensor modules 104, 116, and 119 may include, for example, a first sensor module 104 (e.g., proximity sensor) and/or a second sensor module (not shown) (e.g., fingerprint sensor) disposed on the first surface 110A of the housing 110, and/or a third sensor module 119 (e.g., heart rate monitoring (HRM) sensor) and/or a fourth sensor module 116 (e.g., fingerprint sensor) disposed on the second surface 110B of the housing 110. The fingerprint sensor may be disposed on both the first surface 110A (e.g., the display 101) and the second surface 110B of the housing 110. The electronic device 100 may further include one or more additional sensor modules (not shown), such as gesture sensor, gyro sensor, atmospheric pressure sensor, magnetic sensor, acceleration sensor, grip sensor, color sensor, infrared (IR) sensor, biometric sensor, temperature sensor, humidity sensor, and illuminance sensor.

The camera modules 105, 112, and 113 may include a first camera device 105 disposed on the first surface 110A of the electronic device 100, a second camera device 112 disposed on the second surface 110B, and/or a flash 113. The camera modules 105 and 112 may each include one or more lenses, an image sensor, and/or an image signal processor. The flash 113 may include, for example, a light-emitting diode (LED) or a xenon lamp. In some example embodiments, two or more lenses (e.g., infrared camera, wide-angle, and telephoto lenses) and image sensors may be disposed on one surface of the electronic device 100.

The key input device 117 may be disposed on the side surface 110C of the housing 110. In an example embodiment, the electronic device 100 may not include some or all of the key input devices 117 mentioned above, and the key input device 117 that is not included may be implemented in another form such as a soft key on the display 101. In some example embodiments, the key input device 117 may include the sensor module 116 disposed on the second surface 110B of the housing 110.

The light-emitting element 106 may be disposed on, for example, the first surface 110A of the housing 110. The light-emitting element 106 may provide, for example, state information of the electronic device 100 in flashes of light. In an example embodiment, the light-emitting element 106 may provide, for example, a light source that is linked to the operation of the camera module 105. The light-emitting element 106 may include, for example, an LED, an IR LED, and a xenon lamp.

The connector holes 108 and 109 may include a first connector hole 108 for accommodating a connector (e.g., universal serial bus (USB) connector) for transmitting and receiving power and/or data to and from an external electronic device, and/or a second connector hole 109 (e.g., earphone jack) for accommodating a connector for transmitting and receiving an audio signal to and from an external electronic device.

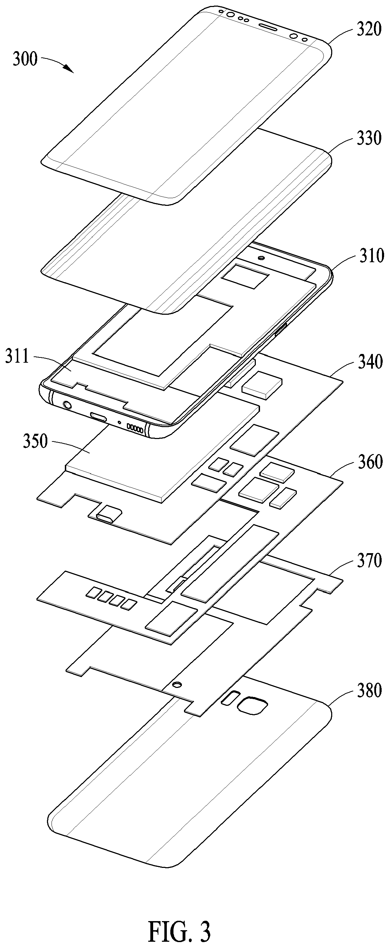

FIG. 3 is an exploded perspective view of the electronic device of FIG. 1. Referring to FIG. 3, an electronic device 300 may include a side bezel structure 310, a first support member 311 (e.g., bracket), a front plate 320, a display 330, a printed circuit board (PCB) 340, a battery 350, a second support member 360 (e.g., rear case), an antenna 370, and a rear plate 380. In some example embodiments, the electronic device 300 may not include at least one (e.g., the first support member 311 or the second support member 360) of the components, or may additionally include other components not shown. At least one of the components of the electronic device 300 may be the same as or similar to at least one of the components of the electronic device 100 of FIG. 1 or 2, and duplicative description thereof will be omitted hereinafter.

The first support member 311 may be disposed inside the electronic device 300 and connected to the side bezel structure 310, or may be integrated with the side bezel structure 310. The first support member 311 may be made of, for example, metal and/or non-metal (e.g., polymer). The display 330 may be connected to one surface of the first support member 311, and the PCB 340 may be connected to another surface of the first support member 311. A processor, a memory, and/or an interface may be mounted on the PCB 340. The processor may include, for example, one or more of a central processing unit, an application processor, a graphics processing unit, an image signal processor, a sensor hub processor, and a communication processor.

The memory may include, for example, a volatile memory or a non-volatile memory.

The interface may include, for example, a high-definition multimedia interface (HDMI), a USB interface, a secure digital (SD) card interface, or an audio interface. For example, the interface may electrically or physically connect the electronic device 300 to an external electronic device, and may include a USB connector, an SD card/multimedia card (MMC) connector, or an audio connector.

In an example embodiment, the battery 350, which is a device for supplying power to at least one component of the electronic device 300, may include, for example, a primary cell that is not rechargeable, a secondary cell that is rechargeable, or a fuel cell. For example, at least a portion of the battery 350 may be disposed on substantially the same plane as the PCB 340. The battery 350 may be disposed integrally inside the electronic device 300, or may be user removable from the electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or may wirelessly transmit and receive power required for charging to and from the external device. In an example embodiment, the antenna structure may be implemented by a portion of the side bezel structure 310 and/or the first support member 311 or a combination thereof.

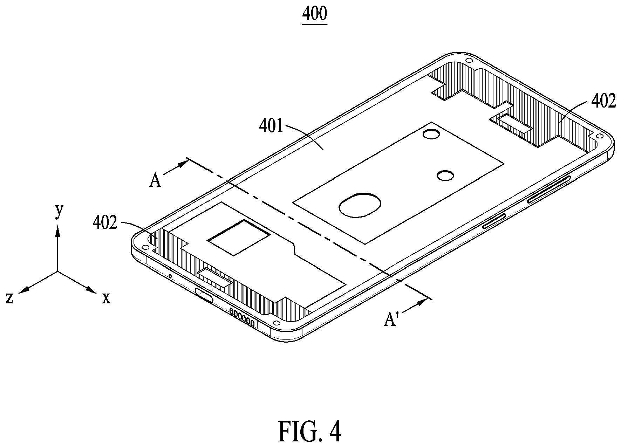

FIG. 4 is a perspective view of an electronic device frame according to an example embodiment.

According to an example embodiment, an electronic device frame 400 of FIG. 4 may be a version of the first support member 311 of FIG. 3. According to an example embodiment, the electronic device frame 400 may include a support member 401 and a side insert portion 402.

According to an example embodiment, the side insert portion 402 may be attached to at least a portion of the support member 401. According to an example embodiment, the side insert portion 402 may include at least one of aluminum (Al), titanium (Ti), stainless steel (SS), amorphous metal, polycarbonate (PC), polybutylene terephthalate (PBT), and polyamide (PA).

According to an example embodiment, the support member 401 and the side insert portion 402 may be individually manufactured and attached to each other to form the electronic device frame 400. The support member 401 and the side insert portion 402 may be attached through coupling, assembling, and/or welding processes. According to an example embodiment, the side insert portion 402 may be attached to at least a portion of the support member 401, and may be formed by injecting a material (e.g., at least one of PC, PBT, and PA) into a mold to form the side insert portion 402.

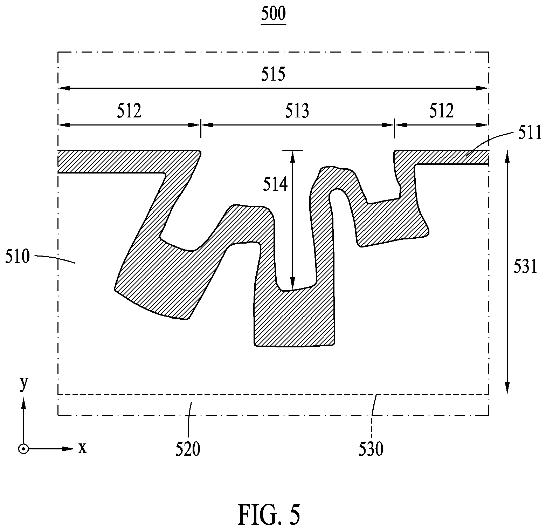

FIG. 5 is a partial cross-sectional view of a support member according to an example embodiment.

According to an example embodiment, FIG. 5 illustrates a cross section of a support member 500, taken along line A-A' of FIG. 4 (e.g., a line perpendicular to a Z-axis).

An electronic device frame according to an example embodiment may include the support member 500. The support member 500 may be used to implement the first support member 311 or the second support member 360 included in the electronic device (e.g., the electronic device 300 of FIG. 3). According to an example embodiment, the support member 500 may include a surface area 510 located in a relative outer portion of the support member 500, and a core area 520 located further inward than the surface area 510. The surface area 510 may include a surface of the support member 500. The surface area 510 and the core area 520 may be distinguished by a line and/or a plane determined according to a predetermined criterion.

According to an example embodiment, an oxide film 511 may be formed on the surface of the support member 500. The support member 500 may include Al, and the oxide film 511 may be formed on the surface of the support member 500 through an anodizing process (anodic oxidation process) to enhance corrosion resistance. According to an example embodiment, the oxide film 511 formed on the surface of the support member 500 may include Al₂O₃. The oxide film 511 formed on the surface of the support member 500 may be included in the surface area 510 of the support member 500.

According to an example embodiment, the support member 500 included in the electronic device frame may include silicon (Si). In the support member 500, the amount of silicon in the surface area 510 and the amount of silicon in the core area 520 may be different from each other. According to an example embodiment, the amount of silicon in the surface area 510 may be less than the amount of silicon in the core area 520.

According to an example embodiment, the surface area 510 of the support member 500 may be uneven. According to an example embodiment, the surface area 510 of the support member 500 may include a planar portion 512 that is substantially flat, and a plurality of concave portions 513 that are irregularly formed. The planar portion 512 may be substantially flat, and the plurality of concave portions 513 may be areas obtained by partially removing an additive element irregularly present in the surface of the support member 500. According to an example embodiment, the concave portions 513 may be generated through a process in which the additional element is removed (e.g., etching using an etching solution (e.g., ammonium fluoride solution, hydrofluoric acid solution, and aqueous nitric acid solution)). The concave portions 513 may be concavely depressed in the direction toward the inside of the support member 500, unlike the planar portion 512. According to an example embodiment, the shapes of the concave portions 513 may be determined according to the shapes of the areas occupied by the additive element and may be referred to as pores. According to an example embodiment, the additive element to be removed may contain Si.

According to an example embodiment, the surface area 510 and the core area 520 of the support member 500 may be distinguished according to various criteria. According to an example embodiment, based on the cross section of the support member 500, the surface area 510 and the core area 520 may be distinguished based on a first line 530 formed at a first depth 531 from the surface in the direction (e.g., a -Y direction) toward the inside of the support member 500. Here, the first line 530 may be based on the cross section of the support member 500 shown in FIG. 5, and one of ordinary skill in the art may clearly understand that in this case, the cross section traverses the plane of the support member 500. According to an example embodiment, the core area 520 may correspond to an area other than the surface area 510 distinguished according to the above criteria in the support member 500.

According to an example embodiment, the surface area 510 may correspond to an area within the first depth 531 from an imaginary plane 515 formed by the planar portion 512 in the direction (e.g., a -Y direction) toward the inside of the support member 500. According to an example embodiment, the surface area 510 may include the planar portion 512 and the concave portions 513, the concave portions 513 may be formed by removing additive elements, and the imaginary plane 515 formed by the planar portion 512 may be a surface of the support member 500 from which the additive element is not removed.

According to an example embodiment, in the cross section of the support member 500, the surface area 510 and the core area 520 may be distinguished based on the first line 530 formed at the first depth 531 from an average line (not shown) of the surface of the surface area 510 in the direction (e.g., -Y direction) toward the inside of the support member 500.

According to an example embodiment, the surface area 510 may have the first depth 531 of 10 µm to 20 µm in the direction (e.g., -Y direction) toward the inside of the support member 500 from the surface. According to an example embodiment, the first depth 531 may be within a range of 10 µm to 20 µm. Preferably, the first depth 531 may be within a range of 10 µm to 15 µm. According to an example embodiment, a ratio of the first depth 531 : the thickness of the support member 500 may range from 1 : 100 to 1 : 4. According to an example embodiment, the thickness of the support member 500 may be calculated based on the cross section of the support member 500.

According to an example embodiment, the oxide film 511 may be formed by an anodizing process. According to an example embodiment, the oxide film 511 may protect the support member 500 from external environment, thereby reducing damage to the support member 500. According to an example embodiment, the oxide film 511 may have a thickness of 5 µm to 15 µm.

According to an example embodiment, the concave portions 513 may have a second depth 514 from the surface of the support member 500 in the direction (e.g., -Y direction) toward the inside of the support member 500. According to an example embodiment, the concave portions 513 may have the second depth 514 from the imaginary plane 515 formed by the planar portion 512 in the direction (e.g., -Y direction) toward the inside of the support member 500. According to an example embodiment, the second depth 514 may be less than or equal to 15 µm. According to an example embodiment, the concave portions 513 may be areas formed by partially removing an additive element of the support member 500. The additive element to be removed and/or a compound of the additive element may be in contact with the surface of the support member 500, or may be located within a depth of 15 µm from the surface of the support member 500. According to an example embodiment, the additive element and/or the compound of the additive element located relatively close (e.g., within 15 µm) to the surface may be removed, and accordingly the concave portions 513 may be formed to have the same or substantially the same shapes as the areas occupied by the removed additive element and/or the removed compound of the additive element. Generally, the concave portions 513 may be recessed from the surface.

According to an example embodiment, the concave portions 513 may be formed by removing a silicon compound included in the surface area 510. According to an example embodiment, the support member 500 may include silicon, and the silicon may be present in the form of a silicon compound. The silicon compound in the surface area 510 may be removed to form the concave portions 513.

According to an example embodiment, when the silicon compound included in the surface area 510 is removed, silicon may not remain on the surface of the support member 500 or may substantially be absent, and the oxide film 511 may be easily formed on the surface thereof. According to an example embodiment, an oxide film may not be formed on a surface of the silicon compound. If silicon compound remains on the surface of the support member, the oxide film, or at least a portion thereof, may be detached from the support member.

According to an example embodiment, the oxide film 511 may be formed using an anodizing process (anodic oxidation process). The oxide film 511 may be formed to cover the surface of the concave portions 513. According to an example embodiment, the oxide film 511 formed on the support member 500 to cover the surface of the concave portions 513 may protect the support member 500 from the external environment and prevent corrosion. According to an example embodiment, due to removal of the additive element such as silicon, the oxide film 511 may be tightly bonded to the support member.

According to an example embodiment, for the surface of the support member 500, an arithmetic average roughness Ra and a ten-point average roughness Rz may be calculated based on its surface roughness. According to an example embodiment, the surface of the support member 500 may have an arithmetic average roughness Ra of 1.2 µm or greater, and a ten-point average roughness Rz of 7.5 µm or greater.

According to an example embodiment, the arithmetic average roughness Ra may be calculated by dividing a value, which is obtained by integrating the distance to the surface profile from the average line of the surface profile, by the length of the average line of the entire surface profile. In addition, the ten-point average roughness Rz may be calculated by adding lengths between the average lines from the top five ridges and the top five valleys based on the average line of the surface profile curve and dividing the sum of the lengths by the length of the average line of the entire surface profile curve.

According to an example embodiment, the amount of silicon in the surface area 510 may be less than the amount of silicon in the core area 520. According to an example embodiment, the amount of silicon in the surface area 510 may be greater than 0% by weight (wt %) and less than or equal to 4 wt %, and the amount of silicon in the core area 520 may range from 5 wt % to 12.5 wt %. According to an example embodiment, since the additive element and/or the compound (e.g., silicon compound) of the additive element are removed, the amount of silicon in the surface area 510 may be less than the amount of silicon in the core area 520. In the process of forming the support member 500, the original amount of silicon may be in a range of 5 wt % to 12.5 wt %, and thus an aluminum alloy containing 5 wt % to 12.5 wt % of silicon, which has high fluidity, may be used.

According to an example embodiment, the aluminum alloy containing 5 wt % to 12.5 wt % of silicon may have high latent heat during solidification, so that the aluminum alloy may be slowly solidified and the fluidity of the aluminum alloy may be increased. In addition, the aluminum alloy containing 5 wt % to 12.5 wt % of silicon may suppress shrinkage that may occur due to expansion of volume during solid-liquid phase change in the solidification process, and may enhance the rigidity of a support member (e.g., the support member 500 of FIG. 5) to be manufactured. According to an example embodiment, the aluminum alloy may be a 6000 series aluminum alloy or a 7000 series aluminum alloy.

According to an example embodiment, the amount of silicon in the surface area 510 may be greater than 0 wt % and less than or equal to 4 wt %. According to an example embodiment, the surface area 510 may include the concave portions 513 by removing the silicon compound, and may reduce the generation of smut caused by the anodizing process of the silicon compound present on the surface. According to an example embodiment, the silicon compound may react with acid and/or base used during the anodizing process to form black smut on the surface, may cause the oxide film 511 to separate from the support member, and may interfere with adhesion to the other components (e.g., the display, the front plate, and the battery) of the electronic device (e.g., the electronic device 300 of FIG. 3). According to an example embodiment, the surface area 510 may be obtained by removing an additive element, for example, the silicon compound, exposed to the surface, may suppress the formation of smut in the subsequent anodizing process, and may enhance corrosion resistance, insulation, and adhesiveness with the other components of the electronic device (e.g., the electronic device 300 of FIG. 3), to prevent separation or damage of the components when the electronic device is dropped.

According to an example embodiment, the support member 500 may further include at least one of copper, magnesium, zinc, manganese, nickel, tin, and titanium. According to an example embodiment, the support member 500 may further include copper, magnesium, zinc, manganese, nickel, tin, and/or titanium. In the support member 500, copper may be included in an amount of 0.015 wt % or greater, magnesium may be included in an amount of 1.2 wt % to 1.7 wt %, zinc may be included in an amount of 0.07 wt % to 0.13 wt %, the manganese may be included in an amount of 0.07 wt % to 0.13 wt %, nickel may be included in an amount of 0.015 wt % or greater, tin may be included in an amount of 0.015 wt % % to 0.035 wt %, and titanium may be included in an amount of 0.17 wt % to 0.25 wt %. According to an example embodiment, in the support member 500, copper may be included in an amount of 0.015 wt % to 0.5 wt %, and nickel may be included in an amount of 0.015 wt % to 0.5 wt %.

According to an example embodiment, the support member 500 may further include at least one metal among silicon, copper, magnesium, zinc, manganese, nickel, tin, and titanium, as an aluminum alloy. According to an example embodiment, the support member 500 may further include silicon, copper, magnesium, zinc, manganese, nickel, tin, and/or titanium, as an aluminum alloy, and the remainder may be formed of aluminum. Here, in the support member 500, copper may be included in an amount of 0.015 wt % or greater, magnesium may be included in an amount of 1.2 wt % to 1.7 wt %, zinc may be included in an amount of 0.07 wt % to 0.13 wt %, manganese may be included in an amount of 0.07 wt % to 0.13 wt %, nickel may be included in an amount of 0.015 wt % or greater, tin may be included in an amount of 0.015 wt % % to 0.035 wt %, and titanium may be included in an amount of 0.17 wt % to 0.25 wt %. According to an example embodiment, in the support member 500, copper may be included in an amount of 0.015 wt % to 0.5 wt %, and nickel may be included in an amount of 0.015 wt % to 0.5 wt %.

According to an example embodiment, an electronic device frame (e.g., the electronic device frame 400 of FIG. 4) may include a support member (e.g., the support member 401 of FIG. 4). The support member may include a surface area (e.g., the surface area 510 of FIG. 5) that includes a surface of the support member, which in turn includes a planar portion (e.g., the planar portion 512 of FIG. 5) and a plurality of concave portions (e.g., the concave portions 513 of FIG. 5), and a core area (e.g., the core area 520 of FIG. 5) corresponding to an area other than the surface area in the support member. The surface area may be an area within a first depth (e.g., the first depth 531 of FIG. 5) from an imaginary plane (e.g., the imaginary plane 515 of FIG. 5) formed by the planar portion in a direction toward the inside of the support member, and the concave portions may each have a second depth (e.g., the second depth 514 of FIG. 5) from the imaginary plane formed by the planar portion in the direction toward the inside of the support member. An oxide film (e.g., the oxide film 511 of FIG. 5) may be formed on the surface of the support member, and an amount of silicon in the surface area may be less than an amount of silicon in the core area.

According to an example embodiment, the first depth (e.g., the first depth 531 of FIG. 5) may range from 10 µm to 20 µm.

According to an example embodiment, a ratio of the first depth (e.g., the first depth 531 of FIG. 5) : a thickness of a cross section of the support member (e.g., the support member 500 of FIG. 5) may range from 1 : 100 to 1 : 4.

According to an example embodiment, the second depth (e.g., the second depth 514 of FIG. 5) may be less than or equal to 15 µm.

According to an example embodiment, the concave portions (e.g., the concave portions 513 of FIG. 5) may be formed by removing a silicon compound of the surface area (e.g., the surface area 510 of FIG. 5).

According to an example embodiment, the oxide film (e.g., the oxide film 511 of FIG. 5) may be formed to cover a surface of the concave portions (e.g., the concave portions 513 of FIG. 5).

According to an example embodiment, the surface of the support member (e.g., the support member 500 of FIG. 5) may have an arithmetic average roughness Ra of 1.2 µm or greater and a ten-point average roughness Rz of 7.5 µm or greater.

According to an example embodiment, the amount of silicon in the surface area (e.g., the surface area 510 of FIG. 5) may be greater than 0 wt % and less than or equal to 4 wt %, and the amount of silicon in the core area (e.g., the core area 520 of FIG. 5) may range from 5 wt % to 12.5 wt %.

According to an example embodiment, in the support member (e.g., the support member 500 of FIG. 5), copper may be included in an amount of 0.015 wt % or greater, magnesium may be included in an amount of 1.2 wt % to 1.7 wt %, zinc may be included in an amount of 0.07 wt % to 0.13 wt %, manganese may be included in an amount of 0.07 wt % to 0.13 wt %, nickel may be included in an amount of 0.015 wt % or greater, tin may be included in an amount of 0.015 wt % to 0.035 wt %, and titanium may be included in an amount of 0.17 wt % to 0.25 wt %.

The electronic device frame (e.g., the electronic device frame 400 of FIG. 4) according to an example embodiment may further include a side insert portion (e.g., the side insert portion 402 of FIG. 4) attached to at least a portion of the support member (e.g., the support member 401 of FIG. 4).

According to an example embodiment, the side insert portion (e.g., the side insert portion 402 of FIG. 4) may include at least one of Al, Ti, SS, amorphous metal, PC, PBT, and PA.

According to an example embodiment, an electronic device may include an electronic device frame (e.g., the electronic device frame 400 of FIG. 4) including a support member (e.g., the support member 500 of FIG. 5), a front plate (e.g., the front plate 320 of FIG. 3) including a display area (e.g., the display 330 of FIG. 3), and a rear plate (e.g., the rear plate 380 of FIG. 3). According to an example embodiment, the support member (e.g., the support member 500 of FIG. 5) may include a surface area (e.g., the surface area 510 of FIG. 5) that includes a surface of the support member that in turn includes a planar portion (e.g., the planar portion 512 of FIG. 5) and a plurality of concave portions (e.g., the concave portions 513 of FIG. 5), and a core area (e.g., the core area 520 of FIG. 5) corresponding to an area other than the surface area in the support member. The surface area (e.g., the surface area 510 of FIG. 5) may be an area within a first depth (e.g., the first depth 531 of FIG. 5) from an imaginary plane (e.g., the imaginary plane 515 of FIG. 5) formed by the planar portion (e.g., the planar portion 512 of FIG. 5) in a direction (e.g., the -Y direction of FIG. 5) toward the inside of the support member, and the concave portions (e.g., the concave portions 513 of FIG. 5) may each have a second depth (e.g., the second depth 514 of FIG. 5) from the imaginary plane (e.g., the imaginary plane 515 of FIG. 5) formed by the planar portion in the direction (e.g., the -Y direction of FIG. 5) toward the inside of the support member. An oxide film (e.g., the oxide film 511 of FIG. 5) may be formed on the surface of the support member, and an amount of silicon in the surface area (e.g., the surface area 510 of FIG. 5) may be less than an amount of silicon in the core area (e.g., the core area 520 of FIG. 5).

According to an example embodiment, an adhesive portion (e.g., an adhesive tape, and/or an adhesive) may be further formed between the support member (e.g., the support member 500 of FIG. 5) and the front plate (e.g., the front plate 320 of FIG. 3). According to an example embodiment, the adhesive portion may maintain a coupling force between the front plate and the support member to enhance waterproof performance.

According to an example embodiment, an electronic device (e.g., the electronic device 100 of FIG. 1) may include an electronic device frame (e.g., the electronic device frame 400 of FIG. 4) including a support member (e.g., the support member 401 of FIG. 4), a front plate (e.g., the front plate 102 in FIG. 1, and the front plate 320 in FIG. 3) including a display area (e.g., the display 101 of FIG. 1), and a rear plate (e.g., the rear plate 111 of FIG. 2, and the rear plate 380 of FIG. 3). The support member may include a surface area (e.g., the surface area 510 of FIG. 5) that includes a surface of the support member that in turn includes a planar portion (e.g., the planar portion 512 of FIG. 5), and a plurality of concave portions (e.g., the concave portions 513 of FIG. 5), and a core area (e.g., the core area 520 of FIG. 5) corresponding to an area other than the surface area in the support member. The surface area may be an area within a first depth (e.g., the first depth 531 of FIG. 5) from an imaginary plane (e.g., the imaginary plane 515 of FIG. 5) formed by the planar portion in a direction toward the inside of the support member, and the concave portions may each have a second depth (e.g., the second depth 514 of FIG. 5) from the imaginary plane formed by the planar portion in the direction toward the inside of the support member. An oxide film (e.g., the oxide film 511 of FIG. 5) may be formed on the surface of the support member, and an amount of silicon in the surface area may be less than an amount of silicon in the core area.

According to an example embodiment, an adhesive portion may be formed between the support member (e.g., the support member 401 of FIG. 4) and the front plate (e.g., the front plate 102 of FIG. 1, and the front plate 320 of FIG. 3).

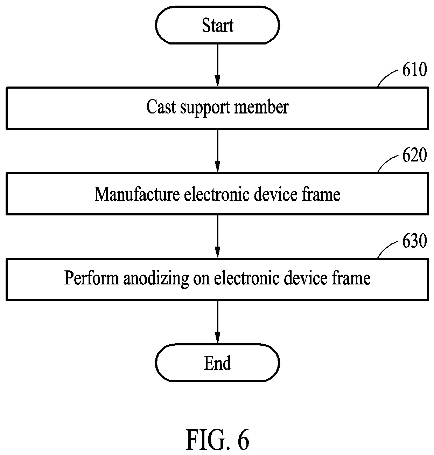

FIG. 6 is a flowchart illustrating a method of manufacturing an electronic device frame according to an example embodiment;

The method of FIG. 6 may include operation 610 of casting a support member, operation 620 of manufacturing an electronic device frame by coupling a side insert portion to the support member, and operation 630 of performing anodizing on the electronic device frame.

According to an example embodiment, operation 610 of casting the support member may be performed using an aluminum alloy containing 5 wt % or greater of silicon. According to an example embodiment, the aluminum alloy containing 5 wt % or greater of silicon may be melted to have sufficient fluidity, so that it is suitable for casting into a mold. According to an example embodiment, 6000 series aluminum alloy or 7000 series aluminum alloy may be used as the aluminum alloy. According to an example embodiment, operation 610 of casting the support member may be performed by melting the aluminum alloy at a temperature of 600°C or higher.

According to an example embodiment, a side insert portion (e.g., the side insert portion 402 of FIG. 4) may be attached to at least a portion of a support member (e.g., the support member 401 of FIG. 4). According to an example embodiment, the side insert portion may include at least one of Al, Ti, SS, amorphous metal, PC, PBT, and PA.

According to an example embodiment, the support member (e.g., the support member 401 of FIG. 4) and the side insert portion (e.g., the side insert portion 402 of FIG. 4) may be individually manufactured and attached to each other to form an electronic device frame (e.g., the electronic device frame 400 of FIG. 4). The support member and the side insert portion may be attached through coupling, assembling, and/or welding processes. According to an example embodiment, the side insert portion may be attached to at least a portion of the support member, and may be formed by injecting a material (e.g., at least one of PC, PBT, and PA) into a mold to form the side insert portion.

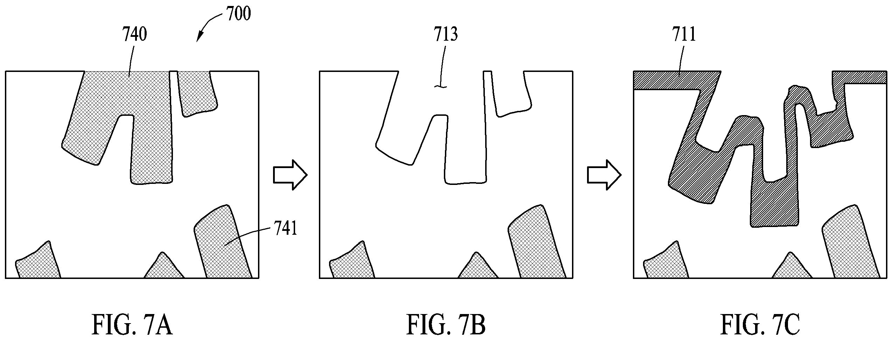

According to an example embodiment, in operation 630, an oxide film may be formed on a surface of the electronic device frame (e.g., the electronic device frame 400 of FIG. 4). According to an example embodiment, as shown in FIG. 7C, an oxide film 711 may be formed on a surface of a support member 700 (e.g., the support member 500 of FIG. 5) included in the electronic device frame by operation 630. According to an example embodiment, the oxide film formed on the surface of the electronic device frame (e.g., the electronic device frame 400 of FIG. 4) may protect the electronic device frame from the external environment, prevent corrosion, and enhance corrosion resistance. According to an example embodiment, the oxide film 711 formed on the surface of the electronic device frame may include Al or Ti, and may have various colors to implement an aesthetically pleasing appearance.

According to an example embodiment, the oxide film 711 may be formed through operation 630 to correspond to the shape of the surface of the support member 700, as shown in FIG. 7C. According to an example embodiment, the support member 700 may include a plurality of uneven portions (e.g., recesses 713) on the surface thereof, and the oxide film 711 may be continuously formed to cover the surface of the support member 700 by anodizing the entire surface of the support member 700, regardless of the uneven portions.

FIGS. 7A to 7C are schematic diagrams of an interface weakening process of a support member according to an example embodiment.

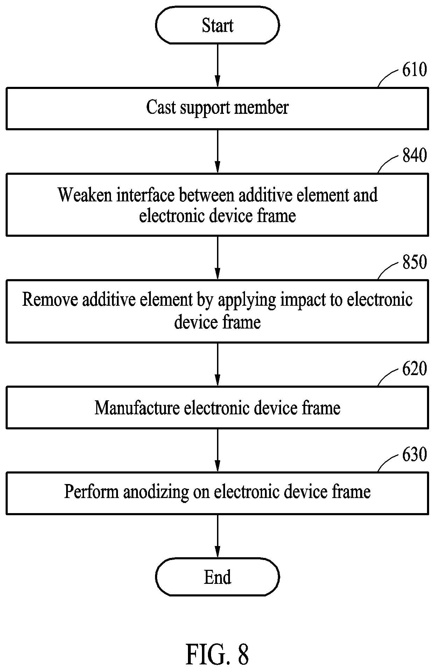

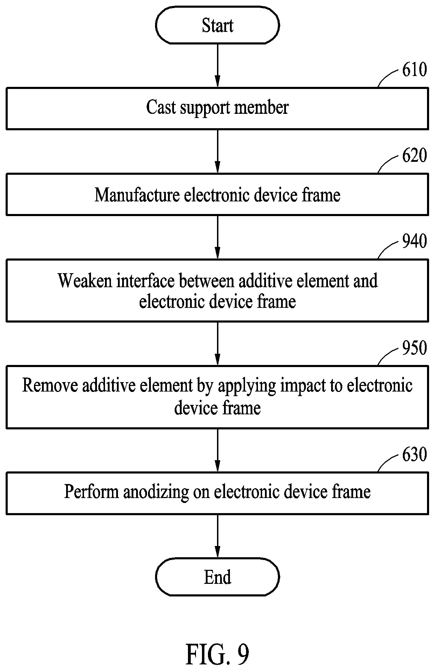

FIGS. 8 and 9 are flowcharts illustrating methods of manufacturing an electronic device frame according to certain example embodiment.

According to an example embodiment, the support member 700 cast according to operation 610 may include a large amount of an additive element 740. According to an example embodiment, the additive element 740 may include a silicon compound. According to an example embodiment, the casting of the support member may be performed by melting an aluminum alloy containing 5% by weight or more of silicon and putting the melted aluminum alloy into a mold, followed by cooling. During the cooling process, the silicon may be crystallized in the form of the silicon compound (e.g., the additive element 740 of FIG. 7A) due to the difference in solubility of silicon and the rest of the aluminum alloy at certain temperatures. According to an example embodiment, the silicon compound on the surface of the support member may interfere with the formation of the oxide film according to operation 630 and may be removed by a process that will be described below.

According to an example embodiment, the method of manufacturing the electronic device frame may further include operation 840 of weakening an interface between an additive element on the surface of the support member and the electronic device frame, after operation 610. According to an example embodiment, the method of manufacturing the electronic device frame may further include operation 940 of weakening the interface between the additive element on the surface of the support member and the electronic device frame, after operation 620. According to an example embodiment, the additive element may include a silicon compound.

According to an example embodiment, operations 840 and 940 may be performed to remove the additive element from the aluminum alloy, by etching the aluminum alloy at the interface between the aluminum alloy and the silicon compound.

According to an example embodiment, in operations 840 and 940, an etching solution containing at least one of ammonium fluoride, hydrofluoric acid, and nitric acid may be used. Operations 840 and 940 may be performed for an operation period of 180 seconds to 3,000 seconds and/or under an operation temperature of 25°C to 90°C. According to an example embodiment, the etching solution used in operations 840 and 940 may contain at least one of ammonium fluoride, hydrofluoric acid, and nitric acid in the amount of 3 wt % to 7 wt %. According to an example embodiment, etching may be performed on the interface of the additive element by operations 840 and 940. For example, the support member 700 that mainly includes aluminum may be partially etched on the interface of the additive element 740 that mainly includes silicon.

According to an example embodiment, in operations 840 and 940, the additive element 740, for example, the silicon compound, on the surface of the support member may be removed. According to an example embodiment, in the operation of weakening the interface of the silicon compound, the additive element 740, for example, the silicon compound, located within 10 µm to 20 µm from the surface of the support member 700 may be removed. According to an example embodiment, in the support member 700 of FIG. 7A, a concave portion 713 may be formed by removing the additive element through operations 840 and 940, as shown in FIG. 7B.

According to an example embodiment, operations 840 and 940 may be performed to remove only the additive element 740 located on the surface of the support member 700, and an additive element 741 located in a core portion (e.g., the core area 520 of FIG. 5) may not be removed. In the support member 700 (e.g., the support member 500 of FIG. 5), the amount of the additive element (e.g., silicon) in the surface portion (e.g., the surface area 510 of FIG. 5) and the amount of the additive element in the core portion (e.g., the core area 520 of FIG. 5) may be different from each other. According to an example embodiment, in the support member 700 (e.g., the support member 500 of FIG. 5), the amount of the additive element (e.g., the silicon compound) in the surface portion (e.g., the surface area 510 of FIG. 5) may be less than the amount of the additive element (e.g., a silicon compound) in the core portion (e.g., the core area 520 of FIG. 5).

According to an example embodiment, the method of manufacturing the electronic device frame may further include, after operations 840 and 940, operations 850 and 950 of removing the additive element by applying impact(s) to the electronic device frame. According to an example embodiment, operations 850 and 950 may be performed to remove the residual additive element 740 (e.g., silicon compound) on the aluminum alloy by applying a uniform external force to the surface of the support member 700 at the interface of the additive element 740. Here, a typical physical impact method (e.g., shot blasting, shot peening, and/or ultrasonic cleansing in hot water) according to the conventional arts may be used.

A method of manufacturing an electronic device frame according to an example embodiment may include an operation (e.g., operation 610 of FIG. 6) of casting a support member, an operation (e.g., operation 620 of FIG. 6) of manufacturing an electronic device frame by coupling a side insert portion to the support member, and an operation (e.g., operation 630 of FIG. 6) of performing anodizing on the electronic device frame.

According to an example embodiment, the method may further include an operation (e.g., operation 840 of FIG. 8 and operation 940 of FIG. 9) of weakening an interface between an additive element on a surface of the support member or the electronic device frame, after an operation (e.g., operation 610 of FIG. 8) of casting a support member or an operation (e.g., operation 620 of FIG. 9) of manufacturing an electronic device frame.

According to an example embodiment, the method may further include an operation (e.g., operation 850 of FIG. 8 and operation 950 of FIG. 9) of removing the additive element by applying an impact to the electronic device frame, after the operation (e.g., operation 840 of FIG. 8 and operation 940 of FIG. 9) of weakening the interface between the additive element on the surface of the support member and the electronic device frame.

The electronic device according to an example embodiment may be one of various types of electronic devices. The electronic device may include, for example, a portable communication device (e.g., a smartphone), a computer device, a portable multimedia device, a portable medical device, a camera, a wearable device, or a home appliance device. According to an example embodiment of the present disclosure, the electronic device is not limited to those described above.

It should be appreciated that certain example embodiments of the present disclosure and the terms used therein are not intended to limit the technological features set forth herein to particular example embodiments and include various changes, equivalents, or replacements for a corresponding example embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and may refer to components in other aspects (e.g., importance or order) is not limited. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

According to certain example embodiments, each component (e.g., a module or a program) of the above-described components may include a single entity or multiple entities, and some of the multiple entities may be separately disposed in different components. According to certain example embodiments, one or more of the above-described components may be omitted, or one or more other components may be added. Alternatively or additionally, a plurality of components (e.g., modules or programs) may be integrated into a single component. In such a case, according to certain example embodiments, the integrated component may still perform one or more functions of each of the plurality of components in the same or similar manner as they are performed by a corresponding one of the plurality of components before the integration..

While the present disclosure has been shown and described with reference to various embodiments thereof, it will be understood by those skilled in the art that various changes in form and details may be made therein without departing from the present disclosure as defined by the appended claims and their equivalents.

## Claims

1. An electronic device frame comprising:
a support member,
wherein the support member comprises:
a surface area comprising a surface of the support member that includes a planar portion and a plurality of concave portions; and
a core area corresponding to an area other than the surface area in the support member,
wherein the surface area is an area within a first depth from an imaginary plane formed by the planar portion in a direction toward an inside of the support member,
wherein the concave portions each have a second depth from the imaginary plane formed by the planar portion in the direction toward the inside of the support member,
wherein an oxide film is formed on the surface of the support member, and
wherein an amount of silicon included in the surface area is less than an amount of silicon included in the core area.

2. The electronic device frame of claim 1, wherein the first depth ranges from 10 µm to 20 µm.

3. The electronic device frame of claim 1, wherein a ratio of the first depth : a thickness of a cross section of the support member ranges from 1 : 100 to 1 : 4.

4. The electronic device frame of claim 1, wherein the second depth is less than or equal to 15 µm.

5. The electronic device frame of claim 1, wherein the concave portions are formed by removing a silicon compound of the surface area.

6. The electronic device frame of claim 1, wherein the oxide film is formed to cover a surface of the concave portions.

7. The electronic device frame of claim 1, wherein the surface of the support member has an arithmetic average roughness (Ra) of 1.2 µm or greater, and a ten-point average roughness (Rz) of 7.5 µm or greater.

8. The electronic device frame of claim 1, wherein
the amount of silicon in the surface area is greater than 0% by weight (wt %) and less than or equal to 4 wt %, and
the amount of silicon in the core area ranges from 5 wt % to 12.5 wt %.

9. The electronic device frame of claim 1, wherein the support member further comprises:
copper in an amount of 0.015 wt % or greater,
magnesium in an amount of 1.2 wt % to 1.7 wt %,
zinc in an amount of 0.07 wt % to 0.13 wt %,
manganese in an amount of 0.07 wt % to 0.13 wt %,
nickel in an amount of 0.015 wt % or greater,
tin in an amount of 0.015 wt % to 0.035 wt %, and
titanium in an amount of 0.17 wt % to 0.25 wt %.

10. The electronic device frame of claim 1, further comprising:
a side insert portion attached to at least a portion of the support member.

11. The electronic device frame of claim 10, wherein the side insert portion includes one or more of aluminum (Al), titanium (Ti), stainless steel (SS), amorphous metal, polycarbonate (PC), polybutylene terephthalate (PBT), and polyamide (PA).

12. An electronic device comprising:
an electronic device frame comprising a support member;
a front plate comprising a display area; and
a rear plate,
wherein the support member comprises:
a surface area comprising a surface of the support member that includes a planar portion and a plurality of concave portions; and
a core area corresponding to an area other than the surface area in the support member,
wherein the surface area is an area within a first depth from an imaginary plane formed by the planar portion in a direction toward an inside of the support member,
wherein the concave portions each have a second depth from the imaginary plane formed by the planar portion in the direction toward the inside of the support member,
wherein an oxide film is formed on the surface of the support member, and
wherein an amount of silicon included in the surface area is less than an amount of silicon included in the core area.

13. The electronic device of claim 12, wherein an adhesive portion is formed between the support member and the front plate.

14. A method of manufacturing an electronic device frame, the method comprising:
casting a support member;
manufacturing the electronic device frame by coupling a side insert portion to the support member; and
performing anodizing on the electronic device frame.

15. The method of claim 14, further comprising, after the casting of the support member or the manufacturing of the electronic device frame:
weakening an interface between an additive element on a surface of the support member or the electronic device frame.
